Europäisches Patentamt

European Patent Office

Office européen des brevets

(11) Veröffentlichungsnummer: **0 035 257**
**A1**

(12) # EUROPÄISCHE PATENTANMELDUNG

(21) Anmeldenummer: **81101447.1**

(51) Int. Cl.³: **H 04 B 1/10**

(22) Anmeldetag: **27.02.81**

(30) Priorität: **03.03.80 DE 3008076**

(43) Veröffentlichungstag der Anmeldung: **09.09.81**
Patentblatt 81/36

(84) Benannte Vertragsstaaten: **AT BE CH DE FR GB IT LI LU NL SE**

(71) Anmelder: **SIEMENS AKTIENGESELLSCHAFT Berlin und München, Postfach 22 02 61, D-8000 München 22 (DE)**

(72) Erfinder: **Müller, Friedrich, Dipl.-Ing., Maxhofstrasse 74, D-8000 München 71 (DE)**

(54) Einrichtung zur Empfängerabschaltung bei kleinem Signal-Geräusch-Abstand für ein digital moduliertes Funksystem.

(57) Eine Einrichtung zur Empfängerabschaltung bei kleinem Signal-Geräusch-Abstand für ein digital moduliertes Funksystem soll derart ausgebildet werden, dass eine schnelle Abschaltung gewährleistet ist, wie sie insbesondere bei beweglichen Funksystemen mit sehr schnellen Pegelschwankungen erforderlich ist. Hiezu ist vorgesehen, dass im Empfänger ein FSK-Demodulator (4) mit zwei eingangsseitig parallelgeschalteten Kanälen mit jeweils einem Bandpass (5), einem Verstärker (6) und einem Detektor (7) vorgesehen ist, die ausgangsseitig an einen Spannungskomparator (8) angeschaltet sind. Das Ausgangssignal des Spannungskomparators (8) wird dem einen Eingang eines im Empfangszweig liegenden Und-Gatters (14) und ferner über die Reihenschaltung aus einer Hochpassschaltung (9), einem Demodulator (10) und einem Tiefpass (11) dem invertierenden Eingang eines weiteren Komparators (12) zugeführt, an dessen nicht invertierenden Eingang über einen veränderlichen Spannungsteiler (13) eine Vergleichsspannung angeschlossen ist. Sein Ausgang ist mit dem anderen Eingang des Und-Gatters (14) verbunden.

EP 0 035 257 A1

0035257

SIEMENS AKTIENGESELLSCHAFT
Berlin und München

Unser Zeichen
VPA  80 P 6 5 3 9 E

Einrichtung zur Empfängerabschaltung bei kleinem Signal-Geräusch-Abstand für ein digital moduliertes Funksystem

Die Erfindung bezieht sich auf eine Einrichtung zur Empfängerabschaltung bei kleinem Signal-Geräusch-Abstand für ein digital moduliertes Funksystem, insbesondere ein Funksystem zur Nachrichtenübertragung zwischen sich längs vorgegebener Strecken bewegenden Sende-/Empfangsstationen und längs dieser Strecken in vorgegebenen Abständen angeordneten Sende-/Empfangsstationen.

Bei einem derartigen Funksystem zur Nachrichtenübertragung zwischen sich längs vorgegebener Strecken bewegenden Sende-/Empfangsstationen und längs dieser Strecken in vorgegebenen Abständen angeordneten Sende-/Empfangsstationen, wie es beispielsweise durch die DE-OS 26 44 206 bekannt ist, können mehrere ortsfeste Sende-/Empfangsstationen von einer beweglichen Sende-/Empfangsstation gleiche Nachrichtsignale empfangen. Mehrere ortsfeste Sende-/Empfangsstationen lassen sich bezüglich ihres Empfängerausganges derart parallelschalten, daß die Sende-/Empfangsstationen, die momentan übertragungsbedingt keine Nachricht empfangen, einen festen Nullpegel abgeben, dabei jedoch das Nachrichtensignal der Sende-/Empfangsstationen, die gerade empfangen, nicht gestört wird. Zusätzlich sollen dabei aber auch die einzelnen Sende-/Empfangsstationen bei übertragungsbedingter Unterschreitung eines vorgegebenen minimalen Signal-Geräusch-Abstandes S/N das Ausgangssignal 0 abgeben. Da bei beweglichen Funksystemen

Klu 1 Mai / 29.2.80

0035257
80 P 6 5 3 9 E

naturgemäß sehr schnelle Pegelschwankungen auftreten,
muß dieser Abschaltvorgang auch schnell genug, bezogen
auf die Datenrate der zu übertragenden binären Nachricht, sein.

Der Erfindung liegt die Aufgabe zugrunde, eine Einrichtung zur Empfängerabschaltung bei kleinem Signal-Geräusch-Abstand zu schaffen, mit der eine den vorstehend
dargelegten Forderungen entsprechende schnelle Abschaltung gewährleistet ist.

Diese Aufgabe wird gemäß der Erfindung in der Weise
gelöst, daß im Empfänger ein FSK-Demodulator mit zwei
eingangsseitig parallelgeschalteten Kanälen mit jeweils einem Bandpaß, einem Verstärker und einem Detektor vorgesehen ist, die ausgangsseitig an einen Spannungskomparator angeschaltet sind, dessen Ausgangssignal dem einen Eingang eines im Empfangsweg liegenden UND-Gatters und ferner über die Reihenschaltung
aus einer Hochpaßschaltung, einem Detektor und einem
Tiefpaß dem invertierenden Eingang eines weiteren Komparators zugeführt wird, an dessen nicht invertierenden Eingang über einen veränderlichen Spannungsteiler
eine Vergleichsspannung angeschlossen ist und dessen
Ausgang mit dem anderen Eingang des UND-Gatters verbunden ist.

Im Empfangsweg zwischen dem Empfangsmischer und dem
FSK-Demodulator ist dabei in vorteilhafter Weise ein
die Ausgangsgangsspannung der beiden FSK-Kanäle bei
jedem S/N-Verhältnis konstant haltender spannungsgeregelter Vorverstärker eingeschaltet.

Nachstehend wird die Erfindung anhand von in der Zeichnung dargestellten Ausführungsbeispielen näher erläutert.

Es zeigen

Fig. 1 die schematische Darstellung eines beweglichen
       Funksystems und

Fig. 2 die Empfängerabschaltung.

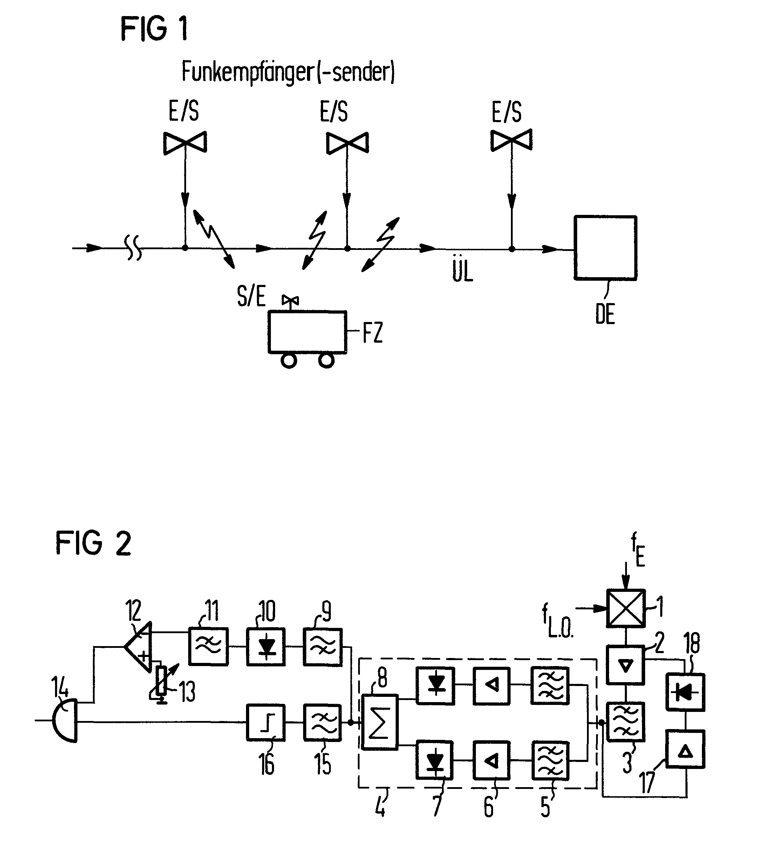

Beim Funksystem nach Fig. 1 sind längs einer Übertragungsstrecke in vorgegebenen Abständen Funkempfänger
(-Sender) E/S angeordnet, die mit einem auf einem vorbeifahrenden Fahrzeug FZ angeordneten Funksender
(-Empfänger) S/E in Funkverbindung stehen. Die von den
ortsfesten Funkempfängern (-Sendern) E/S empfangenen
Nachrichten werden über eine Übertragungsleitung ÜL
an einen zentralen Datenempfänger DE gegeben.

Der Empfangsteil der ortsfesten Sende-/Empfangsstation
und die Empfängerabschaltung sind in Fig. 2 dargestellt.
Das empfangene Signal der Frequenz $f_E$ wird einem
Empfangsmischer 1 zugeführt, in dem mit der gleichfalls
zugeführten Oszillatorfrequenz $f_{LO}$ die Zwischenfrequenz erzeugt wird. Dem Empfangsmischer 1 sind ein
spannungsgeregelter Vorverstärker 2 und ein Bandpaß 3
nachgeschaltet. An den Bandpaß ist der FSK-Demodulator
4 (strichliert umrandet) angeschlossen aus zwei eingangsseitig parallelgeschalteten Kanälen mit jeweils
der Reihenschaltung aus einem Bandpaß 5, einem Verstärker 6 und einem Detektor 7. Ausgangsseitig sind
die beiden Kanäle an einen Spannungskomparator 8 angeschlossen. Der Ausgang des Bandpasses 3 ist ferner
über einen Verstärker 17 und einen eine Gleichspannung
erzeugenden Detektor 18 mit dem spannungsgeregelten
Vorverstärker 2 verbunden. Der Ausgang des Komparators 8 ist zum einen über einen Hochpaß 9, einen
Detektor 10 und einen Tiefpaß 11 mit dem invertierenden Eingang eines weiteren Komparators 12 verbunden,
an dessen nicht invertierenden Eingang über einen veränderlichen Spannungsteiler 13 eine Vergleichsspannung angeschlossen ist. Der Ausgang des Komparators 12 ist mit dem einen Eingang eines im Empfangsweg liegenden UND-Gatters 14 verbunden. An den zweiten Eingang des UND-Gatters 14 ist der Ausgang des Komparators 8 über einen Tiefpaß 15 und eine Begrenzerschaltung 16 angeschaltet.

Nachstehend wird die Funktion der Abschalteinrichtung erläutert: Im Empfangsteil steuert in dem FSK-Demodulator 4 bei ausreichendem Signal-Geräusch-Abstand S/N das im Takt der empfangenen Modulation abwechselnd von dem einen und dem anderen FSK-Kanal abgegebene Signal den Spannungskomparator 8 um. Mit sinkendem Signal-Geräusch-Abstand S/N entstehen nun in beiden FSK-Kanälen zunehmend einzelne dem Nachrichtensignal überlagerte Rauschspitzen, die ein zusätzliches Umschalten des Spannungskomparators 8 bewirken. Wird das S/N-Verhältnis noch kleiner, so nimmt die Häufigkeit der Rauschspitzen zu und damit auch die Frequenz der Komparatorumschaltung. Da durch den spannungsgeregelten Vorverstärker 2 die Ausgangsspannung der beiden FSK-Kanäle bei jedem S/N-Verhältnis konstant gehalten wird, geben im Falle eines total unterbrochenen Empfangs beide Kanäle ein nicht korreliertes hochverstärktes Rauschsignal ab und steuern damit den Spannungskomparator 8 mit hoher Frequenz um. Dadurch läßt sich nach entsprechender Frequenz-Spannungs-Umwandlung des Ausgangssignals des Spannungskomparators 8 ein Signal gewinnen, das dem S/N-Verhältnis direkt proportional ist. Dies erfolgt in der Weise, daß das Ausgangssignal des Spannungskomparators 8 über die Hochpaßschaltung 9 dem Detektor 10 zugeführt wird. Die nach dem dem Detektor nachgeschalteten Tiefpaß 11 entstandene Gleichspannung, die der Frequenz des am Spannungskomparator 8 entstan-

0035257

80 P 6 5 3 9 E

denen Signals proportional ist und damit dem S/N-Verhältnis, gelangt auf den invertierenden Eingang des weiteren Komparators 12, an dessen nicht invertierenden Eingang über den veränderlichen Spannungsteiler 13 eine Vergleichsspannung angeschlossen ist. Mit der einstellbaren Vergleichsspannung kann dasjenige S/N-Verhältnis eingestellt werden, bei dem der Spannungskomparator 8 den Ausgangspegel O abgibt und damit das den Empfangsweg sperrende UND-Gatter 14 schaltet. Die Abschaltung erfolgt dabei wegen der hochfrequenten Rauschsignalauswertung sehr schnell (Abschaltzeit liegt bei wenigen usec).

2 Patentansprüche
2 Figuren

0035257

## Patentansprüche

1. Einrichtung zur Empfängerabschaltung bei kleinem Signal-Geräusch-Abstand für ein digital moduliertes Funksystem, insbesondere ein Funksystem zur Nachrichtenübertragung zwischen sich längs vorgegebener Strecken bewegenden Sende-/Empfangsstationen und längs dieser Strecken in vorgegebenen Abständen angeordneten Sende-/Empfangsstationen, d a d u r c h g e k e n n z e i c h n e t , daß im Empfänger ein FSK-Demodulator mit zwei eingangsseitig parallelgeschalteten Kanälen mit jeweils einem Bandpaß, einem Verstärker und einem Detektor vorgesehen ist, die ausgangsseitig an einen Spannungskomparator angeschaltet sind, dessen Ausgangssignal dem einen Eingang eines im Empfangsweg liegenden UND-Gatters und ferner über die Reihenschaltung aus einer Hochpaßschaltung, einem Detektor und einem Tiefpaß dem invertierenden Eingang eines weiteren Komparators zugeführt wird, an dessen nicht invertierenden Eingang über einen veränderlichen Spannungsteiler eine Vergleichsspannung angeschlossen ist und dessen Ausgang mit dem anderen Eingang des UND-Gatters verbunden ist.

2. Einrichtung nach Anspruch 1, d a d u r c h g e - k e n n z e i c h n e t , daß im Empfangsweg zwischen dem Empfangsmischer und dem FSK-Demodulator ein die Ausgangsspannung der beiden FSK-Kanäle bei jedem S/N-Verhältnis konstant haltender spannungsgeregelter Vorverstärker eingeschaltet ist.

FIG 1

Funkempfänger(-sender)

E/S

E/S

E/S

ÜL

DE

S/E

FZ

FIG 2

$f_E$

$f_{L.O.}$

12

11

10

9

8

1

2

18

13

14

16

15

4

7

6

5

3

17

**Europäisches Patentamt**

**EUROPÄISCHER RECHERCHENBERICHT**

Nummer der Anmeldung

**0035257**

EP 81101447.1

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | GB - A - 1 355 468 (NATIONAL CASH REGISTER)<br><br>+ Fig; Seite 1, Zeile 94 - Seite 2, Zeile 95 +<br><br>& DE-A-2 248 717<br><br>-- | 1,2 |
| D,A | DE - A1 - 2 644 206 (SIEMENS)<br><br>+ Fig.1-3; Ansprüche 1,7,8; Seite 8, Zeilen 1,2 +<br><br>-- | 1 |
| | DE - A1 - 2 629 404 (CALIFORNIA MICROWAVE)<br><br>+ Fig.1; Seite 4, Zeile 10 - Seite 7, Zeile 24 +<br><br>-- | 1,2 |
| | DIPL.ING.SIEGFRIED JOHN UND GERHARD BERGMANN "Die Fernmessung III", 1963,<br>VERLAG G.BRAUN, Karlsruhe, Seiten 32-38, 75 und 76<br><br>+ Bilder 22, 26c und 55 +<br><br>-- | 1,2 |
| | US - A - 3 934 206 (HOLECEK)<br><br>+ Figur +<br><br>-- | 1,2 |
| | US - A - 3 728 634 (WATKINSON)<br><br>+ Fig.3; Spalte 4, Zeile 45 - Spalte 5, Zeile 33 +<br><br>---- | 1,2 |

**KLASSIFIKATION DER ANMELDUNG (Int. Cl.³)**

H 04 B 1/10

**RECHERCHIERTE SACHGEBIETE (Int. Cl.³)**

H 04 B 1/00

H 04 B 7/00

H 04 B 15/00

H 04 Q 7/00

H 04 L 27/00

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

| | Der vorliegende Recherchenbericht wurde für alle Patentansprüche erstellt. |
|---|---|
| X | |

| Recherchenort | Abschlußdatum der Recherche | Prüfer |
|---|---|---|
| WIEN | 05-06-1981 | DRÖSCHER |

EPA form 1503.1   06.78